# EUROPÄISCHE PATENTSCHRIFT

(11) **EP 3 667 348 B1**
(45) Veröffentlichungstag und Bekanntmachung des Hinweises auf die Patenterteilung: **19.07.2023**
(21) Anmeldenummer: 18212446.1
(22) Anmeldetag: 13.12.2018
(51) Int. Cl.: G01R 33/28, G01R 33/36, G01R 33/54

(54) **VORRICHTUNG UND VERFAHREN ZUR B1 BEGRENZUNG**
DEVICE AND METHOD FOR B1 LIMITATION
DISPOSITIF ET PROCÉDÉ DE LIMITATION B1

(43) Veröffentlichungstag der Anmeldung: 17.06.2020
(73) Patentinhaber: Siemens Healthcare GmbH, 91052 Erlangen (DE)
(72) Erfinder: Martschenko, Georg, 90431 Nürnberg (DE); Nistler, Jürgen, 91056 Erlangen (DE); Vester, Markus, 90471 Nürnberg (DE); Wünsch, Christian, 90552 Röthenbach a.d.Pegnitz (DE)

(56) Entgegenhaltungen:
- DE-A1-102008 063 630
- JP-A- 2006 158 817

## Beschreibung

Die Erfindung betrifft eine Vorrichtung zur B1-Feld Begrenzung sowie ein Verfahren zum Betrieb eines Magnetresonanztomographen mit dieser Vorrichtung. Der Magnetresonanztomograph weist einen Sender zum Erzeugen von Anregungspulsen, eine Antenne zum Aussenden der Anregungspulse, eine Speiseleitung zwischen Sender und einem Speisepunkt der Antenne und einen Spannungssensor auf.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt.

Um die Kernspins möglichst stark anzuregen und ein möglichst starkes Magnetresonanzsignal zu erhalten und so ein besseres Signal-zu-Rausch-Verhältnis (Signal-to-Noise Ratio, SNR) zu erzielen, ist ein möglichst starkes B1-Wechselfeld durch die Anregungspulse erwünscht. Gleichzeitig bestehen jedoch Grenzwerte für das B1-Wechselfeld, die aufgrund regulatorischer Vorschriften nicht zu überschreiten sind, um den Patienten nicht durch Überhitzung mittels absorbierter Leistung und/oder induzierte Spannungen und Ströme zu gefährden. Insbesondere bei niedrigeren Frequenzen, beispielsweise unter 100 MHz, 50 MHz oder 30 MHz ist die erzielbare Feldstärke stark von der Abstimmung und Güte der Antenne abhängig, die sich wiederum durch beispielsweise Größe und Gewicht sowie Lage des Patienten ändern können.

Aus dem Dokument JP 2006 158817 A ist ein Magnetresonanztomograph bekannt. Eine Sendevorrichtung ist über ein Koaxialkabel mit einer Sendeantenne verbunden. Der Abstand zwischen der Sendeantenne und einem Sensor an dem Koaxialkabel beträgt das n/2-fache einer Wellenlänge der auszusendenden Hochfrequenz in dem Koaxialkabel, wobei n eine natürliche Zahl ist.

Das Dokument DE 10 2008 063630 A1 beschreibt ein Verfahren zur Kontrolle einer Hochfrequenzsendeeinrichtung eines Magnetresonanztomographiesystems mit einem Sendeantennensystem mit einer Mehrzahl von Sendekanälen. Es werden zeitabhängig Sendeamplitudenvektoren ermittelt, welche die Hochfrequenz-Spannungsamplituden auf den einzelnen Sendekanälen repräsentieren. Auf Basis einer objektspezifischen Streuparametermatrix, einer Referenz-Streuparametermatrix und der Sendeamplitudenvektoren werden zu bestimmten Sendezeitpunkten im Untersuchungsobjekt absorbierte Hochfrequenzleistungswerte ermittelt und basierend auf einer Vielzahl der ermittelten Hochfrequenzleistungswerte werden eine Anzahl von Kontrollwerten gebildet. Die Hochfrequenzsendeeinrichtung wird in ihrer Funktion eingeschränkt, wenn ein Kontrollwert einen vorgegebenen Grenz-Kontrollwert überschreitet.

Es stellt sich daher die Aufgabe, die Bilderfassung mit Magnetresonanztomographen besser und sicherer zu machen.

Die Aufgabe wird durch einen erfindungsgemäßen Magnetresonanztomographen nach Anspruch 1 sowie das erfindungsgemäße Verfahren zum Betrieb eines Magnetresonanztomographen nach Anspruch 9 gelöst.

Der erfindungsgemäße Magnetresonanztomograph weist einen Sender zum Erzeugen von Anregungspulsen auf. Die Frequenz des Anregungspulses ist die Larmorfrequenz, die ein Kernspin eines zu untersuchenden Elements, meist Wasserstoff, im statischen B0-Feld eines Feldmagneten des Magnetresonanztomographen aufweist. Durch die Gradientenfelder zur räumlichen Auflösung kann die Frequenz des Anregungspulses auch um die Larmorfrequenz beim Feld B0 herum variieren.

Dem Anregungspuls ist dabei eine Wellenlänge Lambda zugeordnet. Die Wellenlänge Lambda ist dabei die Wellenlänge, die das von dem Sender als Anregungspuls erzeugte elektromagnetische Signal aufweist und die sich durch die Ausbreitungsgeschwindigkeit c im Vakuum geteilt durch die Frequenz ergibt.

Der Magnetresonanztomograph weist weiterhin eine Antenne zum Aussenden der Anregungspulse und eine Speiseleitung zwischen Sender und einem Speisepunkt der Antenne auf. Als Speiseleitung wird dabei die elektrische Leitung bezeichnet, die den Anregungspuls von dem Sender zu der Antenne leitet. Die Speiseleitung kann beispielsweise eine Koaxialleitung oder eine Stegleitung sein. Die Speiseleitung kann auch weitere Elemente aufweisen wie beispielsweise einen Leistungsteiler, um das Signal eines Senders auf mehrere Antennen zu verteilen.

Üblicherweise ist die Wellenlänge Lambda auf der Speiseleitung gegenüber einer Wellenlänge einer elektromagnetischen Welle in Vakuum mit der Larmorfrequenz um 10%, 20% oder mehr verkürzt.

Die Antenne ist beispielsweise eine Körperspule, die auch als "Birdcage"-Antenne bezeichnet wird. Der Speisepunkt ist dabei der Übergabepunkt von der Speiseleitung zu der Antenne, der bei einer Birdcage-Antenne an dem Endring liegen. Der Sender muss dabei ausgelegt sein, Anregungspulse mit der Larmorfrequenz mit einer Leistung von einigen hundert Watt bis hin zu Kilowatt zu erzeugen.

Der Magnetresonanztomograph weist weiterhin einen Spannungssensor auf. Der Spannungssensor ist dabei an der Speiseleitung in einem effektiven Abstand mit einem Vielfachen der halben Wellenlänge Lambda gleich n*Lambda/2 von dem Speisepunkt angeordnet, n ist hierbei eine natürliche Zahl.

Als effektiver Abstand n*Lambda/2 wird dabei ein geometrischer Abstand entlang der Speiseleitung ausgehend von dem Speisepunkt bezeichnet, für den sich eine Phasenverschiebung der elektromagnetischen Welle zwischen dem Spannungssensor und dem Speisepunkt von n*180 Grad oder n*Pi ergibt, entsprechend einer Wegstrecke im Vakuum der Länge n*Lambda/2. Der effektive Abstand kann dabei zum einen durch die gegenüber der Lichtgeschwindigkeit im Vakuum durch Dielektrikum und Geometrie reduzierte Ausbreitungsgeschwindigkeit gegenüber der geometrischen Länge verlängert sein. Zum anderen erfolgt auch durch die erfindungsgemäß vorhandene Anpassungsschaltung mit einem oder mehreren Anpassungsgliedern eine Phasenverschiebung, die den effektiven Abstand verändert. Die reale Position des Spannungssensors kann dabei von der berechneten im Rahmen einer Toleranz, beispielsweise der Larmorfrequenz durch ein von Gerät zu Gerät variierende statisches Magnetfeld B0, um mehr als 1%, 2%, 5% oder 10% abweichen.

Der Spannungssensor liefert dabei ein Signal, das von dem elektrischen Potential auf der Speiseleitung an dem Ort des Spannungssensors abhängt.

Auf vorteilhafte Weise liefert der Spannungssensor durch den erfindungsgemäßen effektiven Abstand einen Messwert, der die Spannung am Speisepunkt der Antenne wiedergibt. Das erzeugte magnetische Feld B1 ist im Wesentlichen proportional zum Strom in der Antenne. Die Spannung, die über den Spannungssensor für den Speisepunkt erfasst wird ist wiederum auch für resonante Antennen, bei denen der oszillierende Strom in der Antenne deutlich größer ist als der über die Speiseleitung zugeführte, im Wesentlichen proportional zu dem Strom in der Antenne und damit auch zum B1-Feld der Antenne. Somit stellt die vom Spannungssensor erfasste Spannung ein gutes Maß für das B1-Feld der Antenne dar.

Die Speiseleitung des erfindungsgemäßen Magnetresonanztomographen weist eine Anpassungsschaltung zwischen Spannungssensor und Speisepunkt zur Anpassung der Impedanz der Sendeantenne an die Speiseleitung auf. Die Anpassungsschaltung verursacht durch diese Bauelemente selbst eine Phasenverschiebung. Die Speiseleitung ist dabei so ausgelegt, dass die durch die Länge der Speiseleitung zwischen Spannungssensor und Speisepunkt und durch die Anpassungsschaltung selbst verursachte kumulierte Phasenverschiebung zwischen Spannungssensor und Speisepunkt einer durch eine Wegstrecke im Vakuum der Länge n*Lambda/2 verursachten Phasenverschiebung für den Anregungspuls entspricht, sodass ein Messwert des Spannungssensors die Spannung am Speisepunkt der Antenne wiedergibt.

Auf vorteilhafte Weise ist es möglich, auch bei einer Speiseleitung mit Anpassungsschaltung für die Antenne durch Berücksichtigung der Phasenverschiebung der Anpassungsschaltung bei der Bestimmung des Abstandes des Spannungssensors von dem Speisepunkt eine zuverlässige Messung der Spannung am Speisepunkt und Bestimmung des erzeugten B1-Feldes zu ermöglichen. Weitere vorteilhafte Ausführungsformen sind in den Unteransprüchen angegeben.

In einer denkbaren Ausführungsform des erfindungsgemäßen Magnetresonanztomographen weist die Anpassungsschaltung eine, zwei oder mehr Kapazitäten und/oder Induktivitäten auf. Beispielsweise findet häufig ein Pi-Glied Verwendung als Anpassungsschaltung für Antennen.

Eine Anpassungsschaltung mit Kapazitäten und insbesondere ferritfreien Induktiven bietet in der Umgebung eines Magnetresonanztomographen eine einfache und sichere Möglichkeit, den Sender an die Antenne anzupassen.

In einer möglichen Ausführungsform des erfindungsgemäßen Magnetresonanztomographen weist der Spannungssensor eine kapazitive Ankopplung. Als kapazitive Ankopplung wird hier eine Ankopplung bezeichnet, die auf dem elektrischen Feld und Potential und nicht den fließenden Strömen beruht, insbesondere nicht auf Induktion. Die kapazitive Ankopplung ist darüber hinaus für Frequenzen gegen Null nichtleitend, d.h. der Spannungssensor ist für Gleichspannungen von der Speiseleitung isoliert.

Die kapazitive Ankopplung insbesondere in Verbindung mit einem hochohmigen Spannungssensor minimiert eine Rückwirkung des Sensors auf die Speiseleitung und isoliert zugleich in Bezug auf anliegende Gleichspannungen.

In einer denkbaren Ausführungsform ist der Spannungssensor ausgelegt, ein Signal auszugeben, das proportional zum Quadrat der Spannung auf der Speiseleitung ist. Denkbar ist beispielsweise ein Diodentastkopf.

Auf vorteilhafte Weise erlaubt die quadratische Kennlinie, unmittelbar aus dem Signal des Spannungssensors auf eine Leistung am Speisepunkt und damit direkt auf den quadrierten Wert des B1-Feld und damit einen für die SAR-Belastung relevanten und proportionalen Wert zu schließen.

In einer möglichen Ausführungsform des erfindungsgemäßen Magnetresonanztomographen weist der Magnetresonanztomograph eine Überwachungsschaltung auf. Die Überwachungsschaltung steht mit dem Spannungssensor in Signalverbindung, um ein Signal in Abhängigkeit von der von dem Spannungssensor erfassten Spannung zu empfangen. Die Überwachungsschaltung steht weiterhin mit dem Sender in Signalverbindung. Die Überwachungsschaltung und der Sender sind dabei so ausgelegt, dass die Überwachungsschaltung über die Signalverbindung eine Ausgangsleistung des Senders beeinflussen kann. Die Überwachungsschaltung ist dabei ausgelegt, eine Aussendung durch den Sender zu unterbrechen, wenn ein Signal des Spannungssensors einen vorbestimmten Schwellwert überschreitet. Beispielsweise kann das Signal des Spannungssensors in der Überwachungsschaltung mittels eines Komparators mit einem vorbestimmten Schwellwert verglichen werden. Wird das Signal zu groß und damit eine in den Patienten eingestrahlte Leistung, so kann die Überwachungsschaltung über die Signalverbindung beispielsweise über einen einstellbaren Widerstand ein Eingangssignal des Senders reduzieren oder über einen Schalter ausschalten.

Auf vorteilhafte Weise ermöglichen der Spannungssensor und die Überwachungsschaltung eine Kontrolle der Sendeleistung in Echtzeit.

In einer denkbaren Ausführungsform des erfindungsgemäßen Magnetresonanztomographen weist der Magnetresonanztomograph ein Abstimmelement auf. Das Abstimmelement kann beispielsweise eine veränderliche Kapazität oder Induktivität sein. Dabei ist das Abstimmelement am Ort des Spannungssensors mit der Speiseleitung elektrisch verbunden.

Aufgrund der bereits beschriebenen effektiven Länge der Speiseleitung wirkt das Abstimmelement auf die gleiche Weise wie ein gleichartiges Abstimmelement am Speisepunkt. Gleichzeitig ist es jedoch auf vorteilhafte Weise von der unmittelbaren Umgebung der Bilderfassung beabstandet, sodass beispielsweise Materialien verwendet werden können, die direkt am Ort der Bilderfassung das statische Magnetfeld beeinflussen und die Bilderfassung stören würden. So können z.B. auch motorisch betriebene Abstimmelemente eingesetzt werden.

In einer möglichen Ausführungsform des erfindungsgemäßen Magnetresonanztomographen weist der Sender einen Regeleingang auf. Als Regeleingang wird dabei ein Eingang angesehen, an dem ein Signal angelegt werden kann, wobei das Ausgangssignal des Senders von diesem Signal dann abhängt, beispielsweise die Spannung und Phase des Ausgangssignals. Der Spannungssensor steht in Signalverbindung mit dem Regeleingang.

Auf vorteilhafte Weise ist es so auch möglich, eine Regelung der in den Patienten eingestrahlten Leistung schnell und kostengünstig bereitzustellen.

In einer denkbaren Ausführungsform des erfindungsgemäßen Magnetresonanztomographen weist der Magnetresonanztomograph einen zweiten Sensor auf. Der zweite Sensor ist ausgelegt, ein Signal in Abhängigkeit von einer Amplitude und Phase sowie der Ausbreitungsrichtung eines Hochfrequenzsignals auf der Speiseleitung zu liefern. Beispielsweise kann es sich bei dem zweiten Sensor um einen Richtkoppler handeln.

Auf vorteilhafte Weise erlaubt der zweite Sensor zusätzlich auch einen richtungsabhängigen Leistungsanteil zu erfassen, sodass auch reflektierte Leistungen bestimmt werden können. So kann die Leistung des von dem Sender erzeugten B1-Feldes noch genauer erfasst werden. Gleichzeitig erlaubt der zweite Sensor eine Funktionskontrolle des Spannungssensors.

Das erfindungsgemäße Verfahren zum Betrieb des erfindungsgemäßen Magnetresonanztomographen weist den Schritt auf, ein Signal des Spannungssensors mit der Überwachungsschaltung zu erfassen. In einem anderen Schritt wird das Signal mit einem vorbestimmten Schwellwert durch die Überwachungsschaltung verglichen. In einem weiteren Schritt gibt die Überwachungsschaltung ein Warnsignal bei Überschreiten des vorbestimmten Schwellwertes aus. Das Warnsignal kann beispielsweise über ein Display oder akustisch einem Bediener des Magnetresonanztomographen zugeführt werden oder an eine Steuerung des Magnetresonanztomographen oder den Sender ausgegeben werden, um Gegenmaßnahmen auszuführen. Denkbar ist dabei auch, dass in einem Schritt das Warnsignal dem Sender zugeführt wird und zu einer Unterbrechung oder Begrenzung des Sendesignals führt.

Auf vorteilhafte Weise ermöglicht das erfindungsgemäße Verfahren mittels der zum B1-Feld proportionalen Spannung die SAR-Belastung des Patienten zu überwachen und gegebenenfalls bei Überschreiten der Grenzwerte für die Sicherheit des Patienten zu sorgen.

In einer möglichen Ausführungsform des erfindungsgemäßen Verfahrens weist das Verfahren weiterhin den Schritt auf, zur Kalibrierung eine Relation zwischen dem Signal des Spannungssensors und einer B1-Feldstärke zu bestimmen. Dabei ist es denkbar, beispielsweise mittels einer Feldsonde oder einem Phantom die von einem Anregungspuls erzielte Feldstärke B1 zu bestimmen. Wird dabei auch die Spannung am Spannungssensor während des Anregungspulses erfasst, lässt sich ein Proportionalitätsfaktor von B1 zu gemessener Spannung zur Kalibrierung bestimmen.

Die Kalibrierung erlaubt einen unmittelbaren Schluss von gemessener Spannung am Spannungssensor zu der erzeugten B1-Feldstärke. So kann in Echtzeit das Magnetfeld mittels der Spannung überwacht werden und sofort bei Überschreiten von Grenzwerten der Puls unterbrochen werden, um die Sicherheit des Patienten zu gewährleisten.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen;
- Fig. 2: ein schematisches Diagramm eines Senders, Antenne, Speiseleitung und Spannungssensors eines erfindungsgemäßen Magnetresonanztomographen;
- Fig. 3: einen schematischen Ablaufplan eines erfindungsgemäßen Verfahrens zum Betrieb des Magnetresonanztomographen.

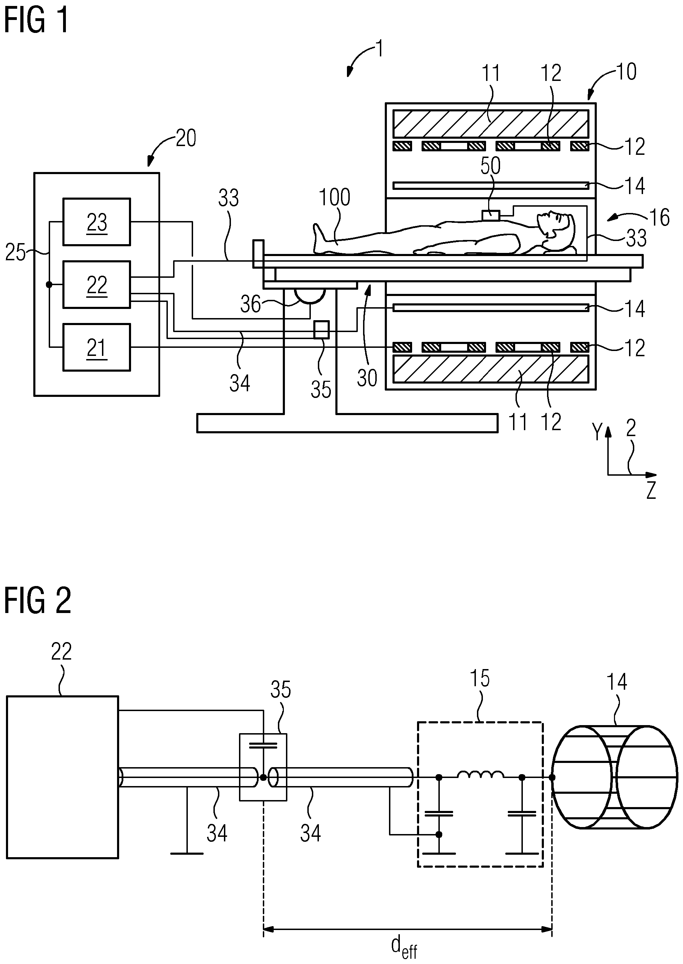

Fig. 1 zeigt eine schematische Darstellung einer Ausführungsform eines Magnetresonanztomographen 1.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Speiseleitung 34 zugeführtes Hochfrequenzsignal in das Untersuchungsvolumen abzustrahlen und von dem Patient 100 emittierte Resonanzsignale zu empfangen und über eine Signalleitung abzugeben. Die Speiseleitung 34 ist an einem Speisepunkt mit der Körperspule 14 elektrisch verbunden. Ein Spannungssensor 35 ist in einem Abstand d entlang der Speiseleitung von dem Speisepunkt elektrisch mit der Speiseleitung 34 verbunden und steht in Signalverbindung mit der Hochfrequenzeinheit 22.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Anschlussleitung 33 mit der Hochfrequenzeinheit 22 und deren Empfänger verbunden ist.

Fig. 2 zeigt den Sender, die Speiseleitung 34, den Spannungssensor 35 sowie die Antenne 14 schematisch in ihrem zusammenwirken.

Die Hochfrequenzeinheit 22 als Sender gibt den Anregungspuls an eine Speiseleitung 34 aus, die die Hochfrequenzeinheit 22 mit der Körperspule 14 als Antenne verbindet. Grundsätzlich ist jedoch auch eine Lokalspule 50 als Antenne denkbar.

Im einfachsten Fall ist die Speiseleitung 34 eine Leitung, die das Hochfrequenzsignal bzw. den Anregungspuls von der Hochfrequenzeinheit 22 zu der Antenne überträgt, in Fig. 2 durch die Körperspule 14 dargestellt. Meist findet hier eine Koaxialleitung Verwendung wegen ihres abschirmenden Außenleiters. Grundsätzlich sind aber auch andere Hochfrequenzleitungen wie Stegleitungen als Speiseleitung 34 denkbar.

In der in Fig. 2 dargestellten Ausführungsform umfasst die Speiseleitung 34 im Sinne der Erfindung darüber hinaus eine Anpassungsschaltung 15, die eine Impedanzanpassung zwischen einer Impedanz der Speiseleitung 34 und der Körperspule 14 vornimmt. Die Anpassungsschaltung 15 kann wie dargestellt durch ein PI-Glied realisiert sein, aber auch durch einzelne oder mehrere Kapazitäten und/oder Induktivitäten. Weiterhin ist es auch denkbar, dass in der Speiseleitung 34 zwischen Sender und Spannungssensor 35 andere Elemente wie beispielsweise ein Leitungsverteiler vorgesehen sind, um die Leistung des Senders auf mehrere Speiseleitungen 34 und Antennen zu verteilen.

Der Spannungssensor 35 ist dabei in einem Abstand d zu dem Speisepunkt, gemessen entlang der Erstreckung der Speiseleitung 34 angeordnet. Gemäß der Erfindung entspricht dabei die durch die Speiseleitung 34 zwischen dem Spannungssensor 35 und dem Speisepunkt für ein Hochfrequenzsignal mit der Larmorfrequenz f_{L} verursachte Phasenverschiebung einem Wert von n*Pi bzw.
n*180 Grad mit n als natürliche Zahl größer Null. Für eine Speiseleitung mit einer fiktiven Ausbreitungsgeschwindigkeit c wie im Vakuum wäre dabei der Abstand d gleich d = n*Lambda/2 mit Lambda = c/f_{L}

Auf einer realen Speiseleitung 34, wie beispielsweise einem Koaxialkabel vom Typ RG213, ist dabei die Ausbreitungsgeschwindigkeit um den Faktor 0,66 reduziert. Damit die Phasenverschiebung sich wie im Vakuum zu c/f_{L} ergibt, ist der effektive Abstand d auf dem Koaxialkabel mit dem Faktor 0,66 zu multiplizieren. Für ein Koaxialkabel RG213 ergibt sich der effektive Abstand
d_{eff} = 0,66*n*Lambda/2 mit Lambda = c/f_{L}

Weitere Korrekturen ergeben sich erfindungsgemäß dadurch, dass die Anpassungsschaltung 15 eine weitere Phasenverschiebung ϕ verursacht. Dann ergibt sich für den effektiven Abstand d_{eff} = 0,66*(n*Lambda *(1/2 - ϕ/(2*Pi))) mit Lambda = c/f_{L}

Der Spannungssensor 35 ist an der Speiseleitung 34 im Abstand d_{eff} zu dem Speisepunkt der Körperspule 14 angeordnet, sodass sich eine Phasenverschiebung von Lambda/2 zwischen dem Spannungssensor 35 und dem Speisepunkt der Antenne bzw. Körperspule 14 ergibt. Aufgrund dieser Phasenverschiebung ergibt sich an dem Ort des Spannungssensors 35 für einen Anregungspuls mit der Larmorfrequenz bzw. Wellenlänge Lambda jeweils ein Spannungswert, der der Spannung am Speisepunkt entspricht.

Das erzeugte magnetische Feld B1 ist im Wesentlichen proportional zum Strom in der Antenne. Die Spannung, die über den Spannungssensor 35 für den Speisepunkt erfasst wird, ist proportional dem Strom in der Antenne und damit auch zum B1-Feld der Antenne. Dies gilt im Wesentlichen auch für den Fall, dass der Strom in der Antenne durch Resonanz größer ist als der über die Speiseleitung zugeführte Strom. Zumindest für typische resonante Antennen mit Güten größer 50 ist dies in guter Näherung erfüllt. Daher ist die Spannung am Spannungssensor 35 mit einem beispielsweise durch eine Kalibrierung gewonnenen Proportionalitätsfaktor ein gutes Maß für das von der Antenne erzeugte B1-Feld.

Der Spannungssensor 35 ist vorzugsweise kapazitiv an die Speiseleitung 34 angekoppelt, um das Sendersignal möglichst wenig zu beeinflussen. Dabei ist eine hohe Impedanz des Spannungssensors von Vorteil. Grundsätzlich wäre aber auch eine ohmsche Kopplung mit hoher Impedanz denkbar, wobei dann keine galvanische Trennung vorliegt.

Denkbar sind auch weitere Sensorensignale, die von der Überwachungsschaltung mit dem Signal des Spannungssensors 35 verknüpft werden, um eine Fehlfunktion eines Sensors zu erkennen. Denkbar sind beispielsweise Richtkoppler in der Speiseleitung 34, die eine reflektierte Leistung oder eine an die Antenne abgegebene Leistung durch ein Sensorsignal an die Hochfrequenzeinheit 22 zurückgeben, um beispielsweise die Anpassung durch die Anpassungsschaltung 15 justieren zu lassen oder die Endstufen zu schützen, indem die Ausgangsleistung der Hochfrequenzeinheit 22 reduziert wird. Die Überwachungsschaltung kann beispielsweise eine Plausbiltätskontrolle durchführen. Wenn einer der Sensorwerte konstant Null ist, während der andere sich mit der Ansteuerung des Senders ändert, kann auf eine Fehlfunktion eines Sensors geschlossen werden und die Überwachungsschaltung zur Sicherheit das Aussenden des Anregungspulses unterbrechen.

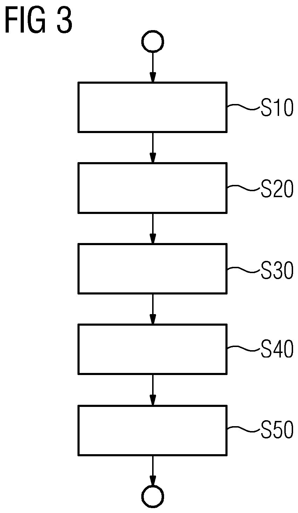

In Fig. 3 ist ein schematischer Ablaufplan eines erfindungsgemäßen Verfahrens zum Betrieb des Magnetresonanztomographen 1 dargestellt.

In einem Schritt S20 wird ein Signals des Spannungssensors 35 mit der Überwachungsschaltung erfasst. Das Signal kann dabei analog von dem Spannungssensor 35 erfasst werden und über eine Signalleitung an die Überwachungsschaltung weitergeleitet werden. Es kann aber beispielsweise auch eine Digitalisierung mit einem A/D-Wandler erfolgen und das digitale Spannungssignal über einen Bus oder eine Leitung weitergegeben werden.

In einem Schritt S30 vergleicht die Überwachungsschaltung das erfasste Spannungssignal des Spannungssensors 35 mit einem vorbestimmten Schwellwert. Der vorbestimmte Schwellwert kann beispielsweise durch regulatorische Vorschriften für eine SAR-Belastung vorgegeben sein. Bei einem analogen Signal kann dies beispielsweise durch einen einfachen Komparator erfolgen, in digitaler Form durch eine fest verdrahtete Logik, um die Zuverlässigkeit zu erhöhen, oder durch eine programmierte Logik in einer Steuerung der Überwachungsschaltung. Die Überwachungsschaltung selbst kann auch durch ein Programm in der Steuerung 23 des Magnetresonanztomographen realisiert sein.

In einem Schritt S40 gibt die Überwachungsschaltung ein Warnsignal aus, wenn der vorbestimmte Schwellwert überschritten wird. Das Warnsignal kann dann beispielsweise akustisch oder über ein Display an eine Bedienperson ausgegeben werden.

Es ist aber auch denkbar, dass das Warnsignal an die Steuerung 23 weitergeleitet wird und diese daraufhin das Aussenden des Anregungspulses unterbricht. Dies erlaubt eine besonders schnelle Reaktion auf ein Überschreiten eines SAR-Grenzwertes.

In einer Ausführungsform des erfindungsgemäßen Verfahrens wird in einem Schritt S10 zur Kalibrierung eine Relation zwischen dem Signal des Spannungssensors und einer B1-Feldstärke bestimmt. Es ist dazu beispielsweise denkbar, dass bei Installation eines Magnetresonanztomographen 1 eine Feldsonde mit der Steuerung 23 verbunden wird, die einen Messwert für ein B1-Feld liefert. Durch gleichzeitiges Erfassen des Signals des Spannungssensors 35 und des Signals der Feldsonde kann so ein Proportionalitätsfaktor zwischen dem B1-Feld durch einen Anregungspuls und dem Signal des Spannungssensors 35 mittels Quotientenbildung bestimmt werden, sodass aus einem erfassten Spannungswert des Spannungssensors 35 auf einen Wert des B1-Feldes geschlossen werden kann.

Denkbar wäre es auch, dass mittels eines Phantoms und einer Bilderfassung auf einen Wert für die Anregung der Kernspins geschlossen wird, aus dem der wiederum in Abhängigkeit von der Dauer des Anregungspulses eine B1-Feldstärke ermittelt wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den durch die Ansprüche definierten Schutzumfang der Erfindung zu verlassen.

## Patentansprüche

1. Magnetresonanztomograph, wobei der Magnetresonanztomograph (1) einen Sender zum Erzeugen von Anregungspulsen mit einer Wellenlänge Lambda, eine Antenne zum Aussenden der Anregungspulse, eine Speiseleitung (34) zwischen Sender und einem Speisepunkt der Antenne und einen Spannungssensor (35) aufweist, wobei der Spannungssensor (35) an der Speiseleitung (34) in einem effektiven Abstand, der einem Vielfachen der halben Wellenlänge Lambda entspricht, von dem Speisepunkt angeordnet ist,
wobei die Speiseleitung eine Anpassungsschaltung (15) zwischen Spannungssensor (35) und Speisepunkt zur Anpassung der Impedanz der Sendeantenne an die Speiseleitung (34) aufweist, **dadurch gekennzeichnet, dass**
die Speiseleitung so ausgelegt ist, dass die durch die Länge der Speiseleitung (34) zwischen dem Spannungssensor (35) und dem Speisepunkt und die durch die Anpassungsschaltung (15) selbst verursachte kumulierte Phasenverschiebung zwischen Spannungssensor und Speisepunkt der Phasenverschiebung einer Speiseleitung (34) der Länge n*Lambda/2 entspricht, wobei n eine natürliche Zahl ist,
sodass ein Messwert des Spannungssensors die Spannung am Speisepunkt der Antenne wiedergibt.

2. Magnetresonanztomograph nach Anspruch 1, wobei die Anpassungsschaltung (15) eine, zwei oder mehr Kapazitäten und/oder Induktivitäten aufweist.

3. Magnetresonanztomograph nach einem der vorhergehenden Ansprüche, wobei der Spannungssensor (35) eine kapazitive Ankopplung aufweist.

4. Magnetresonanztomograph nach einem der vorhergehenden Ansprüche, wobei der Spannungssensor (35) ausgelegt ist, ein Signal auszugeben, das proportional zum Quadrat der Spannung auf der Speiseleitung (34) ist.

5. Magnetresonanztomograph nach einem der vorhergehenden Ansprüche, wobei der Magnetresonanztomograph (1) eine Überwachungsschaltung aufweist, wobei die Überwachungsschaltung mit dem Spannungssensor (35) und dem Sender in Signalverbindung steht und die Überwachungsschaltung ausgelegt ist, eine Aussendung durch den Sender zu unterbrechen, wenn ein Signal des Spannungssensors (35) einen vorbestimmten Schwellwert überschreitet.

6. Magnetresonanztomograph nach einem der vorhergehenden Ansprüche, wobei der Magnetresonanztomograph (1) ein Abstimmelement aufweist, wobei das Abstimmelement am Ort des Spannungssensors (35) mit der Speiseleitung elektrisch verbunden ist.

7. Magnetresonanztomograph nach einem der vorhergehenden Ansprüche, wobei der Sender einen Regeleingang aufweist und der Spannungssensor (35) in Signalverbindung mit dem Regeleingang steht.

8. Magnetresonanztomograph nach einem der vorhergehenden Ansprüche, wobei der Magnetresonanztomograph einen zweiten Sensor aufweist, der ausgelegt ist, ein Signal in Abhängigkeit von einer Amplitude und einer Ausbreitungsrichtung eines Hochfrequenzsignals auf der Speiseleitung (34) zu liefern.

9. Verfahren zum Betrieb eines Magnetresonanztomographen nach einem der Ansprüche 5 bis 8, wobei das Verfahren die Schritte aufweist:
Erfassen eines Signals des Spannungssensors (35) mit der Überwachungsschaltung;
Vergleichen des Signals mit einem vorbestimmten Schwellwert durch die Überwachungsschaltung;
Ausgeben eines Warnsignals durch die Überwachungsschaltung bei Überschreiten des vorbestimmten Schwellwertes.

10. Verfahren nach Anspruch 9, wobei das Verfahren weiterhin den Schritt aufweist, zur Kalibrierung eine Relation zwischen dem Signal des Spannungssensors (35) und einer B1-Feldstärke zu bestimmen.

## Claims

1. Magnetic resonance tomography unit, wherein the magnetic resonance tomography unit (1) comprises a transmitter for generating excitation pulses with a wavelength lambda, an antenna for emitting the excitation pulses, a feed line (34) between the transmitter and a feed point of the antenna and a voltage sensor (35), wherein the voltage sensor (35) is arranged (34) at an effective distance corresponding to a multiple of half the wavelength lambda from the feed point, wherein the feed line comprises a matching circuit (15) between voltage sensor (35) and feed point for matching the impedance of the transmitting antenna to the feed line (34), **characterised in that** the feed line is configured such that the accumulated phase shift between voltage sensor (35) and feed point caused by the length of the feed line (34) between the voltage sensor (35) and the feed point and caused by the matching circuit (15) itself corresponds to the phase shift of a feed line (34) with the length n*lambda/2, wherein n is a natural number, such that a measured value of the voltage sensor reflects the voltage at the antenna feed point.

2. Magnetic resonance tomography unit according to claim 1, wherein the matching circuit (15) comprises one, two or more capacitors and/or inductors.

3. Magnetic resonance tomography unit according to one of the preceding claims, wherein the voltage sensor (35) comprises a capacitive coupling.

4. Magnetic resonance tomography unit according to one of the preceding claims, wherein the voltage sensor (35) is designed to output a signal which is proportional to the square of the voltage on the feed line (34).

5. Magnetic resonance tomography unit according to one of the preceding claims, wherein the magnetic resonance tomography unit (1) comprises a monitoring circuit, wherein the monitoring circuit is in signal communication with the voltage sensor (35) and the transmitter and the monitoring circuit is designed to interrupt a transmission by the transmitter when a signal from the voltage sensor (35) exceeds a predetermined threshold value.

6. Magnetic resonance tomography unit according to one of the preceding claims, wherein the magnetic resonance tomography unit (1) comprises a tuning element, wherein the tuning element is electrically connected to the feed line at the location of the voltage sensor (35).

7. Magnetic resonance tomography unit according to one of the preceding claims, wherein the transmitter comprises a control input and the voltage sensor (35) is in signal communication with the control input.

8. Magnetic resonance tomography unit according to one of the preceding claims, wherein the magnetic resonance tomography unit comprises a second sensor designed to supply a signal in dependence on an amplitude and a propagation direction of a radio-frequency signal on the feed line (34).

9. Method for operating a magnetic resonance tomography unit according to one of claims 5 to 8, wherein the method comprises the steps:
detection of a signal from the voltage sensor (35) with the monitoring circuit;
comparison of the signal with a predetermined threshold value by the monitoring circuit;
outputting a warning signal by the monitoring circuit when the predetermined threshold value is exceeded.

10. Method according to claim 9, wherein the method furthermore comprises the step of determining, for calibration, a relationship between the signal from the voltage sensor (35) and a B1 field strength.

## Revendications

1. Tomodensitomètre à résonnance magnétique, dans lequel le tomodensitomètre (1) à résonnance magnétique a un émetteur de production d'impulsions d'excitation d'une longueur d'onde lambda, une antenne d'émission des impulsions d'excitation, une ligne (34) d'alimentation entre l'émetteur et un point d'alimentation de l'antenne et un capteur (35) de tension, dans lequel le capteur (35) de tension est monté sur la ligne (34) d'alimentation à une distance efficace, qui correspond à un multiple de la demi-longueur d'onde lambda, du point d'alimentation,
dans lequel la ligne d'alimentation a un circuit (15) d'adaptation entre le capteur (35) de tension et le point d'alimentation pour l'adaptation de l'impédance de l'antenne d'émission à la ligne (34) d'alimentation,
**caractérisé en ce que**
la ligne d'alimentation est conçue, de manière à ce que le déphasage cumulé, provoqué par la longueur de ligne (34) d'alimentation entre le capteur (35) de tension et le point d'alimentation et par le circuit (15) d'adaptation soi-même, entre le capteur de tension et le point d'alimentation corresponde au déphasage d'une ligne (34) d'alimentation de longueur n*lambda/2, n étant un nombre naturel,
de manière à ce qu'une valeur de mesure du capteur de tension reproduise la tension au point d'alimentation de l'antenne.

2. Tomodensitomètre à résonnance magnétique suivant la revendication 1, dans lequel le circuit (15) d'adaptation a une, deux ou plusieurs capacités et/ou inductances.

3. Tomodensitomètre à résonnance magnétique suivant l'une des revendications précédentes, dans lequel le capteur (35) de tension a un couplage capacitif.

4. Tomodensitomètre à résonnance magnétique suivant l'une des revendications précédentes, dans lequel le capteur (35) de tension est conçu pour donner un signal, qui est proportionnel au carré de la tension sur la ligne (34) d'alimentation.

5. Tomodensitomètre à résonnance magnétique suivant l'une des revendications précédentes, dans lequel le tomodensitomètre (1) à résonnance magnétique a un circuit de contrôle, dans lequel le circuit de contrôle est en liaison de signal avec le capteur (35) de tension et l'émetteur, et le circuit de contrôle est conçu pour interrompre une émission par l'émetteur, si un signal du capteur (35) de tension dépasse une valeur de seuil déterminée à l'avance.

6. Tomodensitomètre à résonnance magnétique suivant l'une des revendications précédentes, dans lequel le tomodensitomètre (1) à résonnance magnétique a un élément d'accord, dans lequel l'élément d'accord est relié électriquement à la ligne d'alimentation à l'emplacement du capteur (35) de tension.

7. Tomodensitomètre à résonnance magnétique suivant l'une des revendications précédentes, dans lequel l'émetteur a une entrée de réglage et le capteur (35) de tension est en liaison de signal avec l'entrée de réglage.

8. Tomodensitomètre à résonnance magnétique suivant l'une des revendications précédentes, dans lequel le tomodensitomètre à résonnance magnétique a un deuxième capteur, qui est conçu pour fournir un signal en fonction d'une amplitude et d'une direction de propagation d'un signal de haute fréquence sur la ligne (34) d'alimentation.

9. Procédé pour faire fonctionner un tomodensitomètre à résonnance magnétique suivant l'une des revendications 5 à 8, dans lequel le procédé a les stades :
détection d'un signal du capteur (35) de tension par le circuit de contrôle ;
comparaison par le circuit de contrôle, du signal à une valeur de seuil déterminée à l'avance ;
émission d'un signal d'alerte, par le circuit de contrôle, si la valeur de seuil déterminée à l'avance est dépassée.

10. Procédé suivant la revendication 9, dans lequel le procédé a en outre le stade de détermination, pour l'étalonnage, d'une relation entre le signal du capteur (35) de tension et une intensité du champ B1.
